# EUROPEAN PATENT APPLICATION

(11) **EP 2 955 745 A1**
(43) Date of publication of application: **16.12.2015**
(21) Application number: 14171976.5
(22) Date of filing: 11.06.2014
(51) Int. Cl.: H01L 21/67, B28D 5/00

(54) **Wafer cleaning system**

(71) Applicant: Applied Materials Switzerland Sàrl, 1033 Cheseaux-sur-Lausanne (CH)
(72) Inventor: Mercay, Guillaume, 1008 Prilly (CH); Martinez, Raoul, 1053 Cugy VD (CH); Speyrer, John, 1029 Villars-Ste.-Croix (CH); Severico, Ferdinando, 28010 Cavaglietto (IT)
(74) Representative: Zimmermann & Partner Patentanwälte mbB

(57) **Abstract**

A wafer cleaning system (500) for a wire saw (100) including a wire forming a wire web for cutting wafers, comprising at least one cleaning nozzle (540) configured and arranged for providing a cleaning liquid into a space between adjacent wafers from at least one side of the wafers..

## Description

### FIELD OF THE DISCLOSURE

Embodiments of the disclosure relate to a cleaning system for a wire saw and a method for cleaning thin substrates cut from a workpiece, particularly from an ingot. Further, the present disclosure relates to a wire saw for cutting semiconductor material, particularly for fabrication of thin crystalline silicon solar cell substrates from an ingot.

### DESCRIPTION OF THE RELATED ART

Wire saw devices are used in the electronics industry to saw ingots of semiconductor material into thin slices, for example wafers. In conventional wire saw devices, the sawing region may be constituted by an assembly of parallel wire guide cylinders which are engraved with grooves. In the grooves a wire can be guided to form a wire web for cutting the ingot between the wire guide cylinders. The distance between adjacent wires of the wire web determines the thickness of the slices. Conventionally, the piece to be sawed is fixed on a movable support for urging the piece to be sawed against the wire web. For cutting an abrasive may be used. The abrasive can for example be fixed on the wire or be provided in form of slurry. Accordingly, the wire acts as a carrier for the abrasive material.

For numerous applications, the sawed slices, or also referred to as wafers, are of a very small thickness relative to the cross-section, or diameter, of the piece to be sawed. Accordingly, the sawed wafers can be flexible and can come into contact with adjacent wafers which can give rise to undulations, striations and irregularities on the surface of the sawed wafers. These irregularities may render the wafers unusable for certain applications, for example in the solar industry or the semiconductor industry. Particularly, cleaning the sawed sliced remains challenging.

Accordingly, there exists the demand for improving the cleaning of wafers cut from an ingot. Further, the manufacturing process of wafers has to be optimized with respect to the wafer quality in order to produce highly efficient solar cells. Accordingly, there is a need to cost effectively form and manufacture thin semiconductor substrates, particularly for solar cell applications.

### SUMMARY OF THE DISCLOSURE

In light of the above, a wafer cleaning system for a wire saw including a wire forming a wire web for cutting wafers, and a method for cleaning wafers in a wire saw according to the independent claims are provided. Further advantages, features, aspects and details are evident from the dependent claims, the description and the drawings.

According to one aspect of the present disclosure, a wafer cleaning system for a wire saw including a wire forming a wire web for cutting wafers is provided. The wafer cleaning system includes at least one cleaning nozzle configured and arranged for providing a cleaning liquid into a space between adjacent wafers from at least one side of the wafers.

According to another aspect of the present disclosure, a wire saw including a wire cleaning system according to embodiments described herein is provided.

According to a further aspect, an existing wire saw may be retrofitted with the wafer cleaning system as described herein. Accordingly, a method for retrofitting a wire saw is disclosed including providing a wire saw with the wafer cleaning system as described herein.

According to a further aspect of the present disclosure, a method for cleaning wafers in a wire saw including a wire forming a wire web for cutting wafers is provided. The method includes providing a cleaning liquid into a space between adjacent wafers from at least one side of the wafers.

According to a further aspect of the present disclosure, a wafer cleaning system for a wire saw including a wire forming a wire web for cutting wafers is provided. The wafer cleaning system includes at least one cleaning nozzle configured and arranged for providing a cleaning liquid into a space between adjacent wafers from at least one side of the wafers. The at least one cleaning nozzle includes a plurality of cleaning nozzles configured and arranged for providing a cleaning liquid into a space between adjacent wafers from opposite sides of the wafers. Further, the at least one cleaning nozzle is movable relative to the wire web, wherein the at least one cleaning nozzle is coupled to a kinematic mechanism structure, particularly of an ingot feeding system. The at least one cleaning nozzle is directed towards at least one side of the wafers with an inclination angle alpha (α) from alpha = 10° to alpha = 90°, particularly from alpha = 15° to alpha = 80°, more particularly from alpha = 15° to alpha = 70°. Further, the wafer cleaning system further includes a collector tank for collecting the cleaning liquid. The collector tank is arranged between a first wire guide and a second wire guide of the wire saw.

The present disclosure is also directed to an apparatus for carrying out the disclosed methods and including apparatus parts for performing each described method steps. These method steps may be performed by way of hardware components, a computer programmed by appropriate software, by any combination of the two or in any other manner. Furthermore, the disclosure is also directed to methods for operating the described apparatus. It includes method steps for carrying out functions of the apparatus.

### BRIEF DESCRIPTION OF THE DRAWINGS

So that the manner in which the above recited features of the present disclosure can be understood in detail, a more particular description of the disclosure, briefly summarized above, may be had by reference to embodiments. It is to be noted, that the appended drawings illustrate exemplary embodiments and are therefore not to be considered limiting of the scope of the present disclosure. In the drawings:
Fig. 1 shows a schematic view of a wire saw including a wafer cleaning system according to embodiments described herein;
Fig. 2 shows a schematic side view of an excerpt of a wire saw according to embodiments described herein including a wafer cleaning system according to embodiments described herein;
Fig. 3 shows a detailed side view of a cut ingot illustrating the penetration of cleaning liquid into the space between adjacent wafers;
Fig.4 shows a schematic perspective view of an ingot feeding system according to embodiments described herein;
Fig. 5 shows a schematic perspective view of a collector box for a wafer cleaning system according to embodiments described herein arranged between wire guides of a wire saw;
Fig. 6A shows a schematic perspective view of a collector box for a wafer cleaning system according to embodiments described herein
Fig. 6B shows a detailed cross sectional view of a collector box for a wafer cleaning system according to embodiments described herein;
Fig. 7 shows a block diagram illustrating a method for cleaning wafers according to embodiments as described herein;
Figs. 8A to 8C show a schematic side views of an excerpt of a wire saw system according to embodiments described herein including a wafer cleaning system according to embodiments described herein in a first position (Fig. 8A), a second position (Fig. 8B) and a third position (Fig. 8C) for illustrating the method of cleaning during extraction of the wafers from the wire web.

### DETAILED DESCRIPTION OF EMBODIMENTS

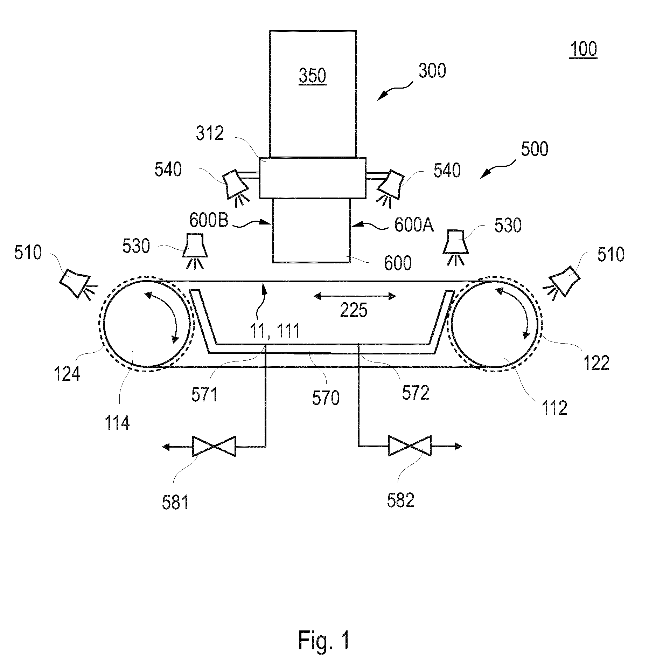

Fig. 1 shows a schematic view of a wire saw 100 including a wafer cleaning system 500 according to embodiments described herein. As exemplarily shown in Fig. 1, the wafer cleaning system 500, may include at least one cleaning nozzle 540 which is configured and arranged for providing a cleaning liquid into a space between adjacent wafers from at least one side of the wafers. The cleaning liquid may for example be water, polyethylene glycol (PEG) or any other suitable cleaning liquid.

In the present disclosure, the expression "providing a cleaning liquid into a space between adjacent wafers from at least one side of the wafers" may be understood as providing cleaning liquid into a space between wafers sawed from an ingot which are separated from each other by slots or sawing gaps. Accordingly, the expression "a space between adjacent wafers" may refer to the slots or sawing gaps between the sawed wafers. Accordingly, the space between sawed wafers may refer to a plurality of spaces between adjacent wafers. Further, the expression "from at least one side of the wafers" in context with "providing a cleaning liquid into a space between adjacent wafers" may be understood as the side of the wafers from which the slots or sawing gaps between the sawed wafers are accessible to cleaning liquid.

According to embodiments of the wafer cleaning system which can be combined with other embodiments described herein, the at least one cleaning nozzle 540 may be configured for providing a confined jet of cleaning liquid. The confined jet of cleaning liquid may have the shape of a blade. For example, the blade of cleaning liquid may have an extension for providing the cleaning liquid into at least 50 %, particularly to at least 75%, more particularly to at least 95%, particularly 100%, of the space between adjacent wafers from at least one side of the wafers at the same time, i.e. not including a movement of the at least one cleaning nozzle relative to the wafers.

According to embodiments of the wafer cleaning system which can be combined with other embodiments described herein, the at least one cleaning nozzle 540 may be configured for varying the position of the confined leaning liquid jet. For example, in embodiments in which the at least one cleaning nozzle is configured for providing a jet of cleaning liquid into less than 100 % of the space between adjacent wafers at the same time, the cleaning nozzle may be pivotable for providing leaning liquid into 100 % of the space between adjacent wafers. Particularly, the at least one cleaning nozzle may be configured to be pivotable relative to the wafers over time such that at least 95%, particularly 100%, of the space between adjacent wafers can be subjected to cleaning liquid. Accordingly, embodiments of the wafer cleaning system as described herein provide an effective system with minimum hardware for in-situ cleaning of wafers in the wire saw. Further by providing a cleaning system as described herein, an existing wire saw may be retrofitted with the wafer cleaning system with minimum additional hardware and in a cost efficient manner.

According to embodiments of the wafer cleaning system which can be combined with other embodiments described herein, the cleaning liquid may be provided into a space between adjacent wafers from at least one side of the wafers for 8 to 20 min, particularly for 10 to 15 min. Additionally or alternatively, the cleaning liquid may be provided into a space between adjacent wafers from at least one side of the wafers at an amount of 6 l/min up to 12 l/min. Further, the cleaning liquid may be water, particularly deionized water, with a temperature of below 50° C (degree Celsius).

With exemplary reference to Fig. 1, according to embodiments of the wafer cleaning system which can be combined with other embodiments described herein, the at least one cleaning nozzle may include a plurality of cleaning nozzles which are configured and arranged for providing a cleaning liquid into a space between adjacent wafers from opposite sides of the wafers. In the exemplary embodiment of Fig. 1, two cleaning nozzles are shown which are directed to towards opposite sides of the wafers.

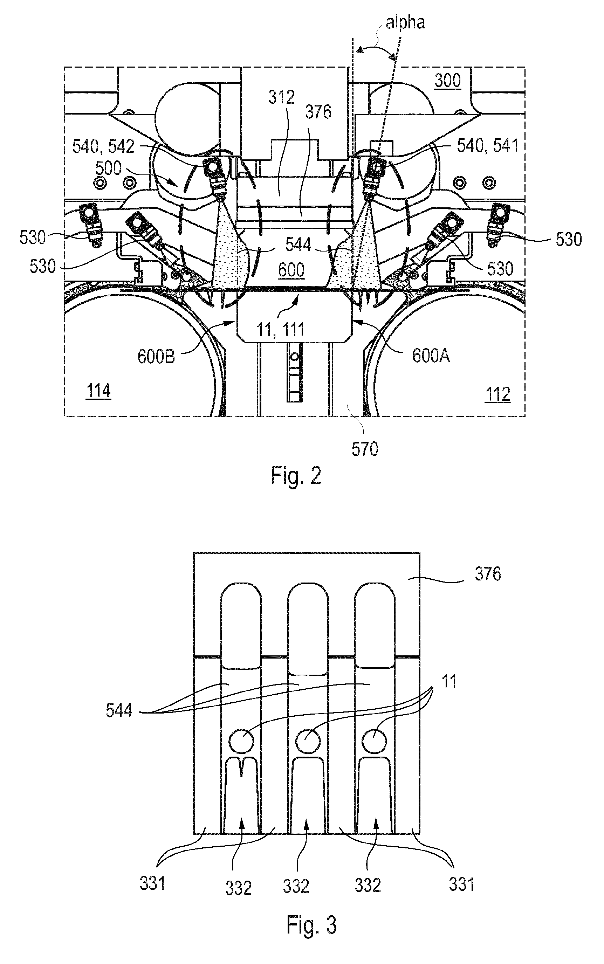

In particular, according to embodiments which can be combined with other embodiments described herein, the wafer cleaning system may include at least one first cleaning nozzle 541 configured and arranged for providing a cleaning liquid into the space between adjacent wafers from a first side 600A of the wafers. Further, according to embodiments which can be combined with other embodiments described herein, the wafer cleaning system may include at least one second cleaning nozzle 542 configured and arranged for providing a cleaning liquid into the space between adjacent wafers from a second side 600B of the wafers. As exemplarily shown in Figs. 1 and 2, the first side 600A of the wafers and the second side 600B of the wafers may face outwards in opposing directions. In particular, the first side 600A of the wafers and the second side 600B of the wafers may be parallel to each other. As exemplarily shown in Fig. 2, the at least one first cleaning nozzle 541 and the at least one second cleaning nozzle 542 may be arranged mirror symmetrically for providing a cleaning liquid 544 into a space between adjacent wafers from opposite sides.

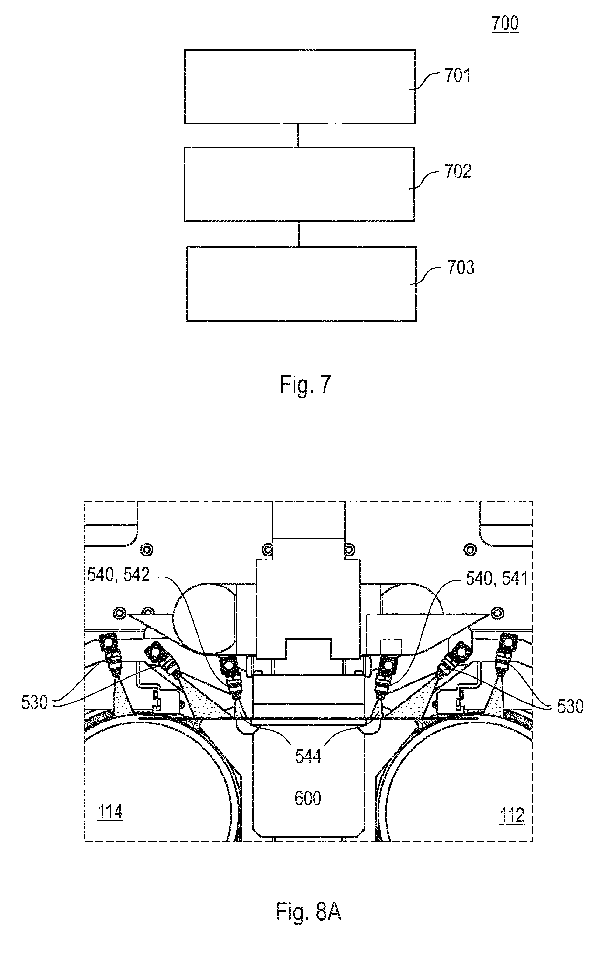

In Fig. 3 a detailed cross-sectional side view of an ingot 600 attached to a mounting plate 376 is shown, wherein the ingot 600 has been cut into wafers 331. As exemplarily shown in Fig. 3, according to embodiments described herein the cleaning liquid provided by the at least on cleaning nozzle may penetrate into the space between adjacent wafers. Further, Fig. 3 illustrates the wire 11 of the wire web in the space between adjacent wafers. As exemplarily shown in Fig. 3, according to embodiments described herein the may help to drag the cleaning liquid along the surface of the wafers, when the wire is moved relative to the surface of the wafers and vice versa. Particularly, when the wafers 331 are extracted from the wire web, as exemplarily illustrated in Figs. 8A to 8C, the wire of the wire web between adjacent wafers may help to drag the cleaning liquid 544 along the surface of the wafers. Additionally or alternatively, the wire of the wire web may be moved relative to the wafers, while providing the cleaning liquid into the space between adjacent wafers. For example, the wire of the wire web may be moved back and forth during ingot extraction from the wire web. Further, the wire may prevent that the wafers stick to each other. Accordingly, damages to the surface of the wafers during cleaning may be avoided.

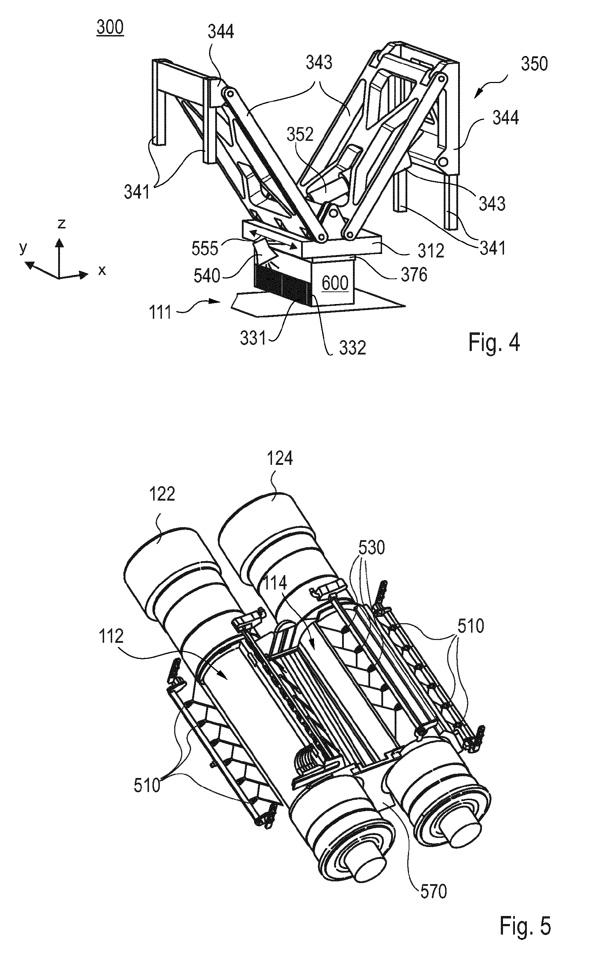

According to embodiments of the wafer cleaning system which can be combined with other embodiments described herein, the at least one cleaning nozzle 540 can be movable relative to the wire web 111. In particular, the at least one cleaning nozzle 540 may be coupled to a kinematic mechanism structure 350, for example of an ingot feeding system 300 as schematically shown in Fig. 1, and explained in more detail with reference to Fig. 4. For example, the at least one cleaning nozzle may be coupled to a support table 312 of the ingot feeding system as exemplarily shown in Fig.1.

Before explaining further embodiments of the wafer cleaning system in more detail, aspects of the wire saw for which the cleaning system may be used are described in the following.

In the present disclosure, "wire saw" may be understood as a device for cutting a workpiece of semiconductor material, particularly into a plurality of slices, for example wafers. Further, in the present disclosure, a workpiece may include one or more separate pieces, for example a plurality of semiconductor pieces or ingots.

In the present disclosure, the terms "sawing" and "cutting" may be used interchangeably. Further, in the present disclosure the process of sawing may correspond to the process of cutting. Accordingly, the verb "to saw" with all adequate grammatical conjugations may be used as having the same meaning as the verb "to cut" with all adequate grammatical conjugations.

In the present disclosure "ingot" may be understood broadly to signify at least one larger piece, or un-cut element, that is to be sawed in the wire saw system. An "ingot" may include one or more separate semiconductor pieces, for example a plurality of semiconductor pieces. Herein, "semiconductor" refers to semiconductor materials such as those used in the photovoltaic industry.

As exemplary shown in Fig. 1, according to embodiments of the wire saw as described herein, a workpiece, e.g. an ingot 600, can be mounted to a support table 312 of the wire saw. Particularly, as exemplarily shown in Fig. 2, a workpiece, e.g. the ingot 600, can be mounted via a mounting plate 376 to the support table 312. The support table 312 can be configured to be moved against the wire 11, particularly against a wire web formed between a first wire guide 112 and a second wire guide 114, in order to cut the ingot into wafers. For example, the support table 312 can be connected to an ingot feeding system 300 as described herein.

Fig. 4 shows a perspective view of an ingot feeding system for a wire saw according to embodiments described herein. According to embodiments described herein, the ingot feeding system 300 includes a kinematic mechanism structure 350, particularly a parallel kinematic mechanism structure. The effect of a parallel kinematic mechanism structure is that it enables a translational movement of the ingot within a cutting plane and a rotational movement around a rotational axis which is particularly perpendicular to the cutting plane.

In the present disclosure, the term "cutting plane" may include the cutting direction. Particularly, the orientation of the cutting plane may remain constant throughout the cutting process and/ or the extraction of the cut ingot from the wire web after cutting. In particular, the orientation of the cutting plane may correspond to the orientation of the wires of the wire web of the wire saw.

Further, in the present disclosure the term "cutting direction" may be understood as the direction in which the cut advances during the cutting process. Particularly, the cutting direction can be a vertical direction. Accordingly, the extraction direction, i.e. the direction at which a cut ingot is extracted from the wire web after cutting may be opposite to the cutting direction.

In the present disclosure, the term "kinematic mechanism structure" may refer to any means configured for providing a rotational and/or transversal movement. Particularly, a "kinematic mechanism structure" as described herein can relate to an arrangement of at least two elements, typically connecting at least two bodies, wherein the at least two elements are connected to each other such that at least one of the at least two elements is movable relative to the other element or elements of the at least two elements of the arrangement, e.g. by rotation around an articulation and/or translation along an axis.

In the present disclosure, the term "parallel kinematic mechanism structure" may relate to a "kinematic mechanism structure" in which at least one of the at least two bodies is connected to the "parallel kinematic mechanism structure" at two or more different locations. Accordingly, a movement of one of the elements of the parallel kinematic mechanism structure typically translates into a movement of at least a part of the kinematic mechanism structure (e.g. another element of the kinematic mechanism structure).

With exemplary reference to Fig. 4, according to embodiments described herein the kinematic mechanism structure 350 may be used for urging an ingot 600 against the wires for wafer cutting. Further, the kinematic mechanism structure may be used for extracting the ingot which has been cut into a plurality of wafers from the wire web, as exemplarily described in connection with Figs. 8A to 8C. As exemplary shown in Fig. 4, according to embodiments which can be combined with other embodiments described herein, the at least one cleaning nozzle may be couple to the kinematic mechanism structure 350. Accordingly, the kinematic mechanism structure 350 may be used for moving the at least one cleaning nozzle 540 relative to the wire web 111.

As shown in Fig. 4, according to embodiments described herein, the kinematic mechanism structure 350 may include at least two arms 343 having first ends and second ends, and at least one actuator 352. According to embodiments at least one of the at least two arms 343 may be an expanding/contracting arm. As exemplarily shown in Fig. 4, the first ends of the at least two arms 343 can be rotatably connected to the support table 312, e.g. via a hinged joint, whereas the second ends of the at least two arms 343 can be rotatably connected to at least one slide 344, particularly via a hinged joint.

According to embodiments which can be combined with other embodiments described herein, the at least one slide 344 may be provided with an actuator which is configured to realize a movement along a translational axis, particularly a vertical axis. Further, as exemplarily shown in Fig. 4, the at least one slide 344 may be guided via guide rails 341. The guide rails can be arranged along an axis of the cutting direction, particularly in a vertical direction. For example, when the slide actuators (not shown) are moving the slides in the same direction with the same speed, e.g. referring to Fig 4 downwards or upwards, the ingot can be urged towards the wires of the wire web or moved upwards away from the wires of the wire web, respectively. In case that at least one of the slide-actuators is moving at a different speed and/or in a different direction compared to the other slide-actuator, a rotational movement of the ingot can be realized. Accordingly, a relative motion of the slide-actuators to each other and to the rails can be used to move the ingot 600 in a cutting plane and/or also to provide a tilt of the ingot 600, e.g. with an angle relative to the wire web 111. Further, according to embodiments described herein the kinematic mechanism structure 350 may be configured for providing a rocking movement of the ingot relative to the wire web. It is to be understood, that movement during cutting of an ingot as described above may be performed in similar way when the cut ingot is extracted from the wire web, particularly when the method for cleaning wafers according to embodiments described herein is performed.

For better understanding, in Fig. 4 a perspective view of an ingot 600 is shown that is partially cut into wafers. According to embodiments described herein, the distance between adjacent wafers may be defined by the distance between adjacent wires of the wire web. As exemplarily shown in Figs. 3 and 4, the wafers 331 cut from an ingot 600 can be separated from each other by slots or sawing gaps 332. As exemplarily shown in Fig. 4, according to embodiments describe herein, the at least one cleaning nozzles may be coupled to the support table of the ingot feeding system. Further, as indicated by the arrow 555, the at least one cleaning nozzles 540 may be configured to be movable along transversal direction, particularly, the at least one cleaning nozzles 540 may be movable perpendicular to the cutting direction, for example along a side surface of the support table, e.g. by means of a linear actuator.

With exemplary reference to Fig. 1, according to embodiments described herein, the wire saw may include at least two wire guides, particularly a first wire guide 112 and a second wire guide 114. According to embodiments described herein, a wire web is formed between the first wire guide 112 and the second wire guide 114 by a wire which is guided by the first wire guide 112 and the second wire guide 114. During cutting, the first wire guide 112 and the second wire guide 114 can be rotated for moving the wire web relative to a workpiece to be sawed. Particularly, the workpiece to be sawed may be an ingot of semiconductor material from which wafers are cut by the wire web.

The first wire guide 112 and the second wire guide 114 may be connected to a first drive 122 and a second drive 124 for rotating the first wire guide 112 and the second wire guide 114, respectively (shown in dashed lines in Fig. 1). The first wire guide 112 and the second wire guide 114 may be adapted for performing a back-and-forth movement of the wire 11 and the wire web 111, respectively. The back-and-forth movement of the wire is indicated by the arrow denoted with reference number 225 in Fig. 1.

According to embodiments which can be combined with other embodiments described herein, the first wire guide 112 and the second wire guide 114 may be rotated by the first drive 122 and the second drive 124 in order to move the wire 11 forming the wire web 111 at a relatively high speed, for example, with a wire speed of 10 m/s or higher, typically in a range of 15 to 20 m/s or even up to 25 m/s or 40 m/s.

The first drive 122 and the second drive 124 driving the wire can be motors having a small momentum in order to stop and accelerate within a short time period. This is particularly useful in embodiments of the present disclosure providing a back-and-forth movement. For example, the direction of wire movement may change at least every 10 sec, at least every 30 sec, or at least every 1 min. Alternatively, a wire saw according to embodiments as described herein may include four wire guides. For example, the wire saw as exemplarily shown in Fig.1 may be supplemented by two further wire guides which are arranged below and parallel to the first wire guide 112 and the second wire guide 114, respectively. Accordingly, a wire saw according to embodiments as described herein may include two parallel wire webs, particularly an upper wire web and a lower web.

According to embodiments of the wire saw, which can be combined with other embodiments described herein, the wire forming the wire web may include a diameter of below about 150 µm, such as diameters between about 100 microns (µm) and about 150 microns (µm), particularly between about 50 microns (µm) and about 150 microns (µm), for example 120 microns (µm), more particularly between 50 microns (µm) and 100 microns (µm), for example 80 microns (µm), 70 microns (µm) or 60 microns (µm).

According to embodiments which can be combined with other embodiments described herein, the wire forming the wire web may include high strength steel for sawing ingots of hard material. For example, the wire employed in the wire saw as described herein may be suitable for cutting silicon, ceramic, compounds of the elements of groups III-V and II-VI, GGG (gadolinium gallium garnet), sapphire, etc., into slices of about 300 microns (µm) or less, particularly of about 180 microns (µm) or less, particularly of about 80 microns (µm) or less in thickness.

According to embodiments of the wafer cleaning system which can be combined with other embodiments described herein, the at least one cleaning nozzle is directed towards the at least one side of the wafers with an inclination angle alpha (α), as exemplarily shown in Fig. 2. The inclination angle alpha (α) of the at least one cleaning nozzle relative to the at least one side can be from alpha = 10° to alpha = 90°, particularly from alpha = 15° to alpha = 80°, more particularly from alpha = 15° to alpha = 70°. In particular, the inclination angle alpha (α) of the at least one cleaning nozzle relative to the at least one side may be alpha = 60°. Further, the inclination angle alpha (α) may be adapted according to the nozzle position, size of the ingot to be sawed etc.

According to embodiments of the wafer cleaning system which can be combined with other embodiments described herein, the inclination angle alpha (α) of the at least one cleaning nozzle may be adjustable. For example, the inclination angle alpha (α) of the at least one cleaning nozzle may be adjustable in dependence of a distance between the support table 312 and the wire web 111. For example, as the distance of the support table relative to the wire web increases (e.g. during extraction of the cut ingot from the wire web) the inclination angle alpha (α) of the at least one cleaning nozzle relative to the at least one side of the wafers may be decreased. For example, the inclination angle alpha (α) of the at least one cleaning nozzle relative to the at least one side of the wafers may be decreased by means of an actuator configured for adjusting the inclination angle alpha (α) of the at least one cleaning nozzle, e.g. by rotation of the at least one cleaning nozzle.

According to embodiments of the wafer cleaning system which can be combined with other embodiments described herein, the wafer cleaning system may further include a collector tank 570 for collecting and/or filtering the cleaning liquid, as exemplarily shown in Figs. 1 and 2. Further, the collector tank may be configured for collecting broken wafers. In particular, the collector tank may protect the lower wire web from broken wafers, e.g. broken silicon wafers, which could damage the wire of the wire web and/or the wire guides. As exemplarily shown in Fig. 5, illustrating a schematic perspective view of the wire guides of the wire saw according to embodiments described herein, the collector tank 570 may be arranged between the first wire guide 112 and the second wire guide 114 of the wire saw.

As exemplarily shown in Figs. 1 and 5, according to embodiments as described herein the wire saw may include a cleaning nozzle arrangement 510 for cleaning the first wire guide 112 and the second wire guide 114. Further, the wire saw may include a process nozzle arrangement 530 for applying slurry to the wire web. The slurry may serve as a transport for abrasive particles applied to the wire for cutting the ingot.

According to embodiments, which can be combined with other embodiments described herein, the collector tank 570 may be adapted to collect cleaning liquid 544 applied by the at least on cleaning nozzle. Further, the collector tank 570 may be adapted to collect slurry applied by the process nozzle arrangement 530 and/or cleaning liquid applied by cleaning nozzle arrangement 510 for cleaning the wire guides.

Further, according to embodiments which can be combined with other embodiments described herein, the collector tank 570 may be adapted to collect remnants of slurry and/or abraded material from the wafer surfaces, for example kerf material. Further, the collector tank 570 may be adapted to collect possibly broken wafers. Accordingly, the collector tank may prevent that broken wafers or other wastes can fall down on the lower wire web, as exemplarily shown in Fig. 1.

According to embodiments, which can be combined with other embodiments described herein, the collector tank 570 may include a first drain line 571 and/or a second drain line 572 as exemplarily shown in Fig. 1. The first drain line 571 may include a first valve 581, and the second drain line 572 may include a second valve 582. The first drain line 571 may be adapted to conduct slurry. Further, the first drain line 571 can be connected to a slurry tank (not shown) so that the slurry collected by the collector tank 570 can be recycled. For example, the slurry can be reprocessed before it may be used again.

According to embodiments, which can be combined with other embodiments described herein, the second drain line 572 can be adapted to conduct a cleaning liquid, particularly water, polyethylene glycol (PEG) or any other suitable cleaning liquid. According to some embodiments described herein, slurry and cleaning liquid do not mix, e.g. for an oilbased slurry and a water-based cleaning liquid. Accordingly, slurry and cleaning liquid can be separated and may be treated separately. For example, the second valve 582 may be closed during the sawing process while slurry is applied. The slurry applied during the sawing process may be drained via the first drain line 571 when the first valve 581 is open. After the slurry has been drained, the first valve 581 can be closed and the second valve 582 may be opened. Then, a cleaning liquid may be applied, for example by the at least one cleaning nozzle of the wafer cleaning system as described herein. The cleaning liquid may be collected by the collector tank 570 and may be drained via the second drain line 572 when the second valve 582 is open.

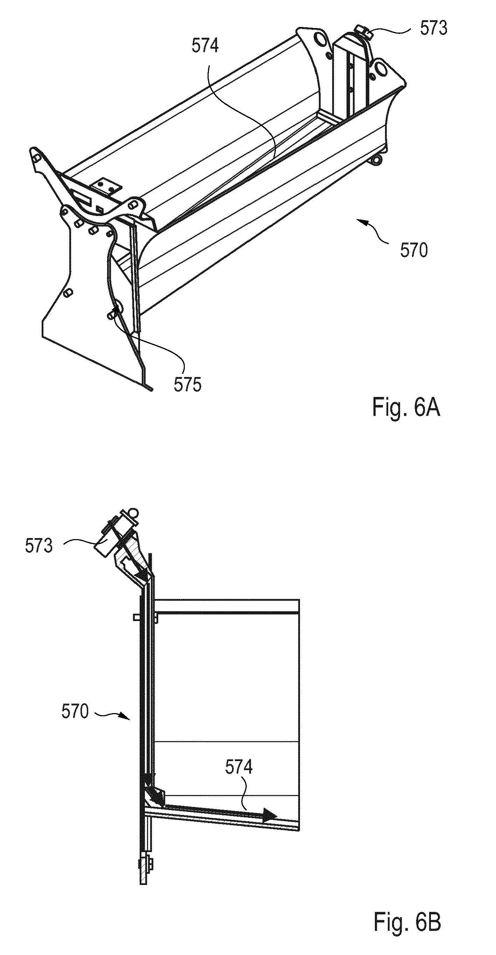

Fig. 6A shows a schematic perspective view of a collector tank 570 for a wafer cleaning system according to embodiments described herein. According to embodiments, which can be combined with other embodiments described herein, the collector tank 570 may include a flush 573 for providing a cleaning liquid into the collector tank, as exemplarily shown in Figs. 6A and 6B. Further, the flush 573 may be configured for providing cleaning liquid into the collector tank in order to flush waste material, for example broken wafers, slurry, or kerf material out of the collector tank into, for example, a separate waste container.

According to embodiments, which can be combined with other embodiments described herein, a sidewall and/or a bottom wall of the collector tank 570 may include at least one opening through which slurry and/or cleaning liquid and/or other waste material may be dispensed from the collector tank. Particularly, the collector tank may include an outlet 575 for drainage of cleaning liquid and/or waste material from the collector tank, as exemplarily indicated in Fig. 6A.

According to embodiments which can be combined with other embodiments described herein, the bottom 574 of the collector tank may include a structure for prevention of adhesion of waste material on the bottom. Additionally or alternatively, the collector tank may include one or more of a low friction coating, a Teflon coating, a structured Teflon coating and an anti-adhesive coating for prevention of waste, e.g. pieces of broken wafers, sticking to walls of the collector tank. Further, as exemplarily shown in Fig. 6B the bottom of the collector tank may be inclined from the cleaning flush side to an opposing outlet 575. Accordingly, embodiments of the collector tank as described herein provide for smooth flushing. Further, embodiments of the collector tank may effectively prevent clogging.

Fig. 7 shows a block diagram illustrating a method 700 for cleaning wafers according to embodiments as described herein. In particular, the method 700 for cleaning wafers is a method for in-situ cleaning of semiconductor wafers within a wire saw, particularly within a wire saw according to embodiments as described herein.

According to embodiments of the method 700 for cleaning wafers, the method includes providing a cleaning liquid into a space between adjacent wafers from at least one side of the wafers, as exemplary shown by a first block 701 in Fig. 7. Additionally, the method 700 for cleaning wafers may include moving the wafers relative to the wire web, as exemplary shown by a second block 702 in Fig. 7. Particularly, moving the wafers relative to the wire web may include extracting the wafers from the wire web, while providing the cleaning liquid into the space between adjacent wafers. Accordingly, the cleaning efficiency may further be improved. Particularly, moving the wafers relative to the wire web may include dragging the cleaning liquid along the surface of the wafers by the wire of the wire web, as exemplary described in connection with Fig. 3. For example, dragging the cleaning liquid along the surface of the wafers by the wire of the wire web may be performed by , moving the wire relative to the surface of the wafers and vice versa. Particularly, when the wafers 331 are extracted from the wire web, as exemplarily illustrated in Figs. 8A to 8C, the wire of the wire web between adjacent wafers may help to drag the cleaning liquid 544 along the surface of the wafers. Additionally or alternatively, the wire of the wire web may be moved relative to the wafers, while providing the cleaning liquid into the space between adjacent wafers. For example, the wire of the wire web may be moved back and forth during ingot extraction from the wire web while providing the cleaning liquid into the space between adjacent wafers.

According to embodiments of the method 700 for cleaning wafers as described herein, the cleaning liquid may be spread on the sliced ingot, in particular into the space between adjacent wafers during extraction of the sliced ingot is from the wire web 111. The extraction may be performed manually or automatically, for example by means of an ingot feeding system as described herein. Accordingly, the cleaning liquid can penetrate into the space between adjacent wafers to remnants of slurry and/or abraded material from the wafer surfaces.

Further, according to embodiments which may be combined with other embodiments described herein, moving the wafers relative to the wire web may include a rocking movement of the wafers relative to the wire web. Particularly, the rocking movement of the wafers relative to the wire web may be performed by an ingot feeding system according to embodiments described herein. Accordingly, the cleaning efficiency may further be improved.

According to embodiments, which may be combined with other embodiments described herein, the method 700 for cleaning wafers may include moving the wire web relative to the wafers, while providing the cleaning liquid into the space between adjacent wafers, as exemplary shown by a third block 703 in Fig. 7. For example, the wire of the wire web may be moved back and forth during ingot extraction from the wire web. Accordingly, the movement of the wire may help to clean the surface of the wafers, particularly remove kerf material from the space between adjacent wafers. Further, the movement of the wire during extraction of the sliced ingot from the wire web can be beneficial for penetration of cleaning liquid into the space between adjacent wafers. Particularly, as the sliced ingot is extracted from the wire web, the wires of the wire web may move within the space between adjacent wafers, which may be beneficial for cleaning the surface of the wafers. Further, a back and forth movement of the wire during ingot extraction from the wire web and application of the method for cleaning wafers according to embodiments described herein, may further improve the cleaning efficiency.

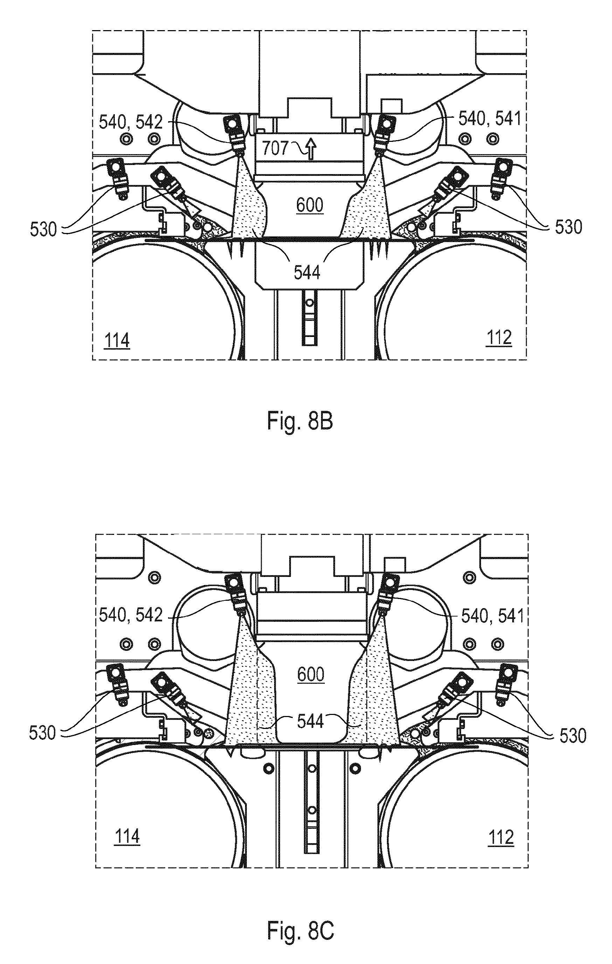

According to embodiments, which may be combined with other embodiments described herein, the method 700 for cleaning wafers may be applied when a cut of an ingot is completed, i.e. when the ingot has been cut into a plurality of wafers. Particularly, as exemplarily shown in Fig. 8A, the method 700 for cleaning wafers may be applied when the ingot has been urged through the wire web of the wire saw, i.e. at a position of the cut ingot which is below the wire web 111. As exemplarily shown in Figs. 8B and 8C illustrating different stages of the extraction of the cut ingot from the wire web, the embodiments of the method for cleaning wafers as described herein may be applied during the full extraction process of the ingot from the web. The extraction process is exemplarily indicated by arrow 707, as shown in Fig. 8B. Particularly, the extraction process of the ingot from the web may be performed by an ingot feeding system as described herein.

According to embodiments, which may be combined with other embodiments described herein, the method 700 for cleaning wafers may be applied until the cut ingot is at a position above the wire web of the wire saw. In Fig. 8C a position of the cut ingot is shown at which the ingot is about to exit the wire web.

Accordingly, embodiments of the wafer cleaning system as well as embodiments of the method for cleaning wafers as described herein provide effective means for in-situ cleaning of wafers in a wire saw. Particularly, the wafer cleaning system and the method for cleaning wafers as described herein provides means for rinsing wafers with cleaning liquid to remove remnants of slurry and/or abraded material from the wafer surfaces in an effective manner.

Further, embodiments of the wafer cleaning system as well as embodiments of the method for cleaning wafers as described herein may be beneficial for reducing the overall wafer manufacturing costs. In particular, by providing a wafer saw with a wafer cleaning system as described herein a separate pre-cleaning tool, which is conventionally used prior to the final wafer cleaning process, may not be necessary.

## Claims

1. A wafer cleaning system (500) for a wire saw (100) including a wire (11) forming a wire web for cutting wafers, comprising at least one cleaning nozzle (540) configured and arranged for providing a cleaning liquid (544) into a space between adjacent wafers from at least one side of the wafers.

2. The wafer cleaning system (500) according to claim 1, wherein the at least one cleaning nozzle (540) includes a plurality of cleaning nozzles configured and arranged for providing the cleaning liquid into the space between adjacent wafers from opposite sides of the wafers.

3. The wafer cleaning system (500) according to claim 1 or 2, wherein the at least one cleaning nozzle (540) is movable relative to the wire web (111), particularly wherein the at least one cleaning nozzle (540) is coupled to a kinematic mechanism structure (350), particularly of an ingot feeding system (300).

4. The wafer cleaning system (500) according to any of claims 1 to 3, wherein the at least one cleaning nozzle is directed towards the at least one side of the wafers with an inclination angle alpha (α) from alpha = 10° to alpha = 90°, particularly from alpha = 15° to alpha = 80°, more particularly from alpha = 15° to alpha = 70°.

5. The wafer cleaning system (500) according to claim 4, wherein the inclination angle alpha (α) of the at least one cleaning nozzle (540) is adjustable.

6. The wafer cleaning system (500) according to any of claims 1 to 5, further comprising a collector tank (570) for collecting the cleaning liquid, wherein the collector tank is arranged between a first wire guide and a second wire guide of the wire saw.

7. The wafer cleaning system (500) according to claim 6, wherein the collector tank comprises a flush (573) for providing the cleaning liquid into the collector tank (570), particularly wherein the collector tank further comprises an outlet (575) for drainage of cleaning liquid from the collector tank.

8. The wafer cleaning system (500) according to claim 6 or 7, wherein the collector tank comprises one or more of a low friction coating, a Teflon coating, a structured Teflon coating and an anti-adhesive coating.

9. The wafer cleaning system (500) according to any of claims 6 to 8, wherein a bottom (574) of the collector tank comprises a structure for prevention of adhesion.

10. A wire saw (100) comprising a wire cleaning system (500) according to any of claims 1 to 9.

11. A method (700) for cleaning wafers in a wire saw including a wire forming a wire web for cutting wafers, wherein the method comprises providing a cleaning liquid into a space between adjacent wafers from at least one side of the wafers.

12. The method (700) for cleaning wafers according to claim 11, further comprising moving (702) the wafers relative to the wire web, particularly extracting the wafers from the wire web, while providing the cleaning liquid into the space between adjacent wafers.

13. The method (700) for cleaning wafers according to claim 12, wherein moving the wafers relative to the wire web includes a rocking movement of the wafers relative to the wire web.

14. The method (700) for cleaning wafers according to any of claims 11 to 13, further comprising moving the wire web relative to the wafers, while providing the cleaning liquid into the space between adjacent wafers.

15. The wafer cleaning system (500) according to claim 1, wherein the at least one cleaning nozzle (540) includes a plurality of cleaning nozzles configured and arranged for providing the cleaning liquid (544) into the space between adjacent wafers from opposite sides of the wafers, wherein the at least one cleaning nozzle is movable relative to the wire web (111), wherein the at least one cleaning nozzle is coupled to a kinematic mechanism structure (350), particularly of an ingot feeding system (300), wherein the at least one cleaning nozzle is directed towards at least one side of the wafers with an inclination angle alpha (α) from alpha = 10° to alpha = 90°, particularly from alpha = 15° to alpha = 80°, more particularly from alpha = 15° to alpha = 70°, wherein the wafer cleaning system further comprises a collector tank (570) for collecting the cleaning liquid, and wherein the collector tank is arranged between a first wire guide (112) and a second wire guide (114) of the wire saw (100).
